# EUROPÄISCHE PATENTSCHRIFT

(11) **EP 0 361 195 B1**
(45) Veröffentlichungstag und Bekanntmachung des Hinweises auf die Patenterteilung: **17.03.1993**
(21) Anmeldenummer: 89116804.9
(22) Anmeldetag: 11.09.1989
(51) Int. Cl.: H05K 3/10, H05K 3/42

(54) **Leiterplatte mit einem spritzgegossenen Substrat**
Printed circuit board with moulded substrate
Plaque à circuit imprimé avec substrat moulé

(30) Priorität: 30.09.1988 DE 3833297
(43) Veröffentlichungstag der Anmeldung: 04.04.1990
(73) Patentinhaber: SIEMENS AKTIENGESELLSCHAFT, 80333 München (DE)
(72) Erfinder: Heerman, Marcel, B-9220 Merelbeke (BE)

(56) Entgegenhaltungen:
- EP-A- 0 051 378
- DE-A- 3 010 610
- US-A- 4 532 152

## Beschreibung

Die Erfindung betrifft eine Leiterplatte mit einem spritzgegossenen Substrat, in dessen Oberfläche das Leiterbild durch grabenförmige Vertiefungen im Bereich von Leiterbahnen und durch flächige Vertiefungen im Bereich von Durchkontaktierungen und/oder Anschlußflächen ausgespart ist und die ausgesparten Bereiche einen leitenden Metallüberzug aufweisen.

Derartige Leiterplatten mit spritzgegossenen oder ähnlich geformten Substraten sind bereits aus der DE-A-27 15 875 bzw. der korrespondierenden CA-A-10 75 825 oder auch aus der US-A-45 32 152 bekannt.

Zur Herstellung der beispielsweise aus der DE-A-27 15 875 bekannten Leiterplatte wird zunächst in einer Form das Substrat gebildet, in welchem das Leiterbild und Durchkontaktierungslöcher in Form von Vertiefungen enthalten sind. Nach einer mechanischen und/oder chemischen Oberflächenbehandlung wird dann das Substrat chemisch aktiviert, worauf die erhabenen Flächen des Substrats mit einer Schutzschicht bedeckt werden. Bei dem Aufbringen dieser Schutzschicht müssen lediglich die Vertiefungen freibleiben, so daß eine aufwendige Fotostrukturierung des Resists entfallen kann und der Auftrag beispielsweise mit einer Rakel oder durch Rollbeschichtung, dem sogenannten Roller-Coating, vorgenommen werden kann. Anschließend wird dann vorzugsweise durch stromlose Metallabscheidung ein leitender Metallüberzug aufgebracht, der in den Vertiefungen des Substrats und in den Durchkontaktierungslöchern zur Bildung der gesamten Leiterkonfiguration führt. Zur Fertigstellung der Leiterplatten wird auf die Leiterflächen, die keine Lötverbindungen eingehen sollen, ein Lötstopplack aufgebracht.

Es ist ersichtlich, daß durch die Strukturierung des Substrats vor der Metallabscheidung keine Fotostrukturierung des Resists erforderlich ist. Demgegenüber erfordert dann aber das Aufbringen des Lötstopplacks entweder ein selektives Auftragen auf die Leiterbahnen oder eine Fotostrukturierung, da die flächigen Vertiefungen welche die Durchkontaktierungen als Lötaugen umgeben oder die als Anschlußflächen dienen sollen freibleiben müssen.

Der Erfindung liegt die Aufgabe zugrunde, eine Leiterplatte mit einem spritzgegossenen Substrat zu schaffen, bei welcher das Aufbringen des Lötstopplacks ohne Fotostrukturierung auf einfache Weise vorgenommen werden kann.

Diese Aufgabe wird bei einer Leiterplatte der eingangs genannten Art erfindungsgemäß dadurch gelöst, daß die Breite der grabenförmigen Vertiefungen derart eng und die Breite der flächigen Vertiefungen derart weit bemessen ist, daß der aufgebrachte Metallüberzug die grabenförmigen Vertiefungen bis zur Oberfläche des Substrats ausfüllt und zwischen dem Metallüberzug in den flächigen Vertiefungen und der Oberfläche des Substrats ein Abstand verbleibt.

Der Erfindung liegt die Erkenntnis zugrunde, daß durch eine Geometrie des Substrats mit entsprechend engen grabenförmigen Vertiefungen beim stromlosen oder stromlos und galvanischen Abscheiden des Metallüberzugs diese Vertiefungen vom Boden und von den Seitenwandungen her zuwachsen bis es zu einer vollständigen Ausfüllung der grabenförmigen Vertiefung kommt. Wenn diese vollständige Ausfüllung der grabenförmigen Vertiefungen erreicht ist, befindet sich in den entsprechend weit bemessenen flächigen Vertiefungen ein Metallüberzug, dessen Stärke nicht bis zur Oberfläche des Substrats reicht und dessen Stärke im seitlichen Wandungsbereich nicht zu einem Ausfüllen der flächigen Vertiefungen führt. Dies hat dann aber andererseits zur Folge, daß bei einem flächigen Auftragen des Lötstopplacks mit einer Rakel, durch Roller-Coating oder dergleichen die Leiterbahnen sicher geschützt werden, während die flächigen Vertiefungen - die ja gerade Lötaugen oder Löt-Pads bilden sollen - freibleiben und insbesondere durch Heißverzinnen zusammen mit den Wandungen der Durchkontaktierungslöcher mit einer Lotschicht überzogen werden können.

Bei der erfindungsgemäßen Leiterplatte wird der Metallüberzug vorzugsweise durch chemisch aufgebrachtes Kupfer gebildet, das ja dann wie bereits erwähnt wurde im Bereich von Lötaugen, Löt-Pads und Durchkontaktierungslöchern mit einer geeigneten Lotschicht, insbesondere Zinn, überzogen wird.

Gemäß einer weiteren bevorzugten Ausgestaltung der Erfindung ist vorgesehen, daß die grabenförmigen Vertiefungen (30) einen annähernd V-förmigen Querschnitt aufweisen. Ein derartiger V-förmiger Querschnitt begünstigt dann das Ausfüllen der grabenförmigen Vertiefungen bei der stromlosen oder stromlos und galvanischen Metallabscheidung.

Ein Ausführungsbeispiel der Erfindung ist in der Zeichnung dargestellt und wird im folgenden näher beschrieben.

Es zeigen
Fig. 1 einen Schnitt durch einen Teil einer Leiterplatte mit einer erfindungsgemäßen Geometrie des spritzgegossenen Substrats und
Fig. 2 bis 6 die wesentlichen Verfahrensstadien bei der Herstellung einer Leiterplatte gemäß Fig. 1.

Vor der detaillierten Beschreibung des Ausführungsbeispiels ist noch darauf hinzweisen, daß der Begriff "Leiterplatte" und auch die Zeichnung zunächst auf ein flächiges Gebilde schließen lassen. Die Vorteile der spritzgegossenen Substrate und die nicht mehr notwendigen Fotostrukturierungen beim Aufbringen eines Plating-Resists und des Lötstopplacks sind jedoch gerade darin zu sehen, daß von der ebenen Form abgewichen werden kann und dreidimensionale Leiterplatten mit beliebigen abgewinkelten oder gekrümmten Formen hergestellt werden können.

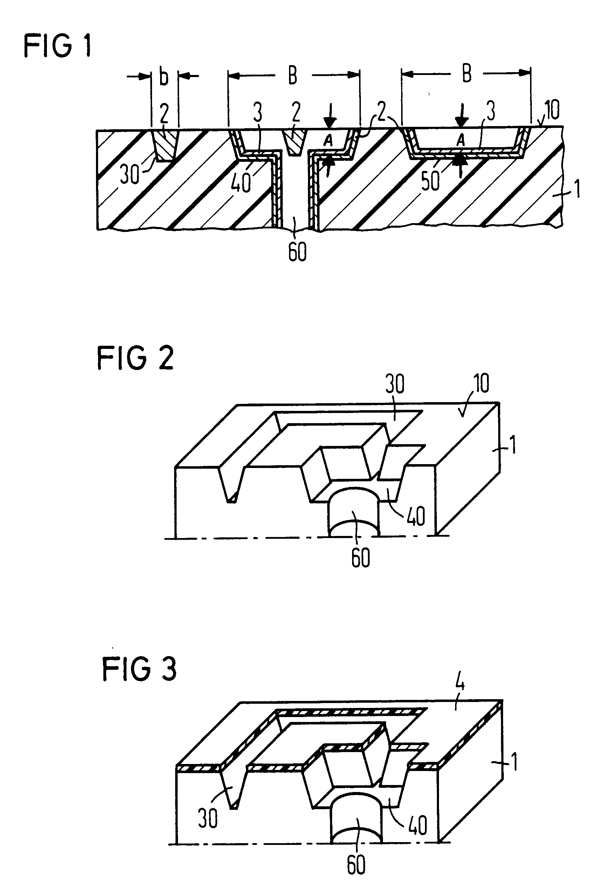

Fig. 1 zeigt einen Schnitt durch einen Teil eines beispielsweise aus glasfaserverstärktem Polyetherimid bestehenden Substrats 1. In dieses Substrat 1 werden bereits beim Spritzgießvorgang im wesentlichen V-förmige grabenförmige Vertiefungen 30 der Breite b, im Bereich von Durchkontaktierungslöcher 60 angeordnete flächenförmige Vertiefungen 40 der Breite B und an anderen Stellen flächenförmige Vertiefungen 50 der gleichen Breite B erzeugt. Es ist zu erkennen, daß durch das Aufbringen eines Metallüberzugs 2 die grabenförmigen Vertiefungen 30 bis zur Oberfläche 10 des Substrats vollständig mit Metall ausgefüllt sind. Dies wird durch eine entsprechend enge Bemessung der Breite b der grabenförmigen Vertiefungen 30 erreicht, die bei der Metallabscheidung am Boden und an den Seitenwandungen der Vertiefung 30 zu deren Zuwachsen führt. Demgegenüber ist bei den flächigen Vertiefungen 40 und 50 deren Breite B so bemessen, daß es keinesfalls zu diesem Zuwachsen kommen kann. In diesen flächigen Vertiefungen 40 und 50 wird der Metallüberzug 2 somit flächig und mit geringer Stärke abgeschieden, so daß hier ein mit A bezeichneter Abstand zur Oberfläche 10 des Substrats 1 verbleibt. Dies bedeutet, daß auch bei gleichen Tiefen der grabenförmigen Vertiefungen 30 einerseits und der flächigen Vertiefungen 40 und 50 andererseits eine im gleichen Bad vorgenommene Metallabscheidung einmal bis zur Oberfläche 10 des Substrats reicht und einmal im Abstand A zur Oberfläche des Substrats 10 endet. Der Abstand A muß dann auf jeden Fall so groß sein, daß bei einer flächigen Beschichtung der Oberfläche 10 mit einem Lötstopplack nur die Leiterbahnen im Bereich der grabenförmigen Vertiefungen 30 aber keineswegs die Lötaugen im Bereich der flächigen Vertiefungen 40 und der Anschlußflächen im Bereich der flächigen Vertiefungen 50 abgedeckt werden. Nach diesem aus Fig. 1 nicht ersichtlichen Aufbringen eines Lötstopplacks können die als Durchkontaktierungen, Lötaugen und Anschlußflächen dienenden Bereiche der Metallschicht 2 durch Heißverzinnen mit einer Zinnschicht 3 überzogen werden.

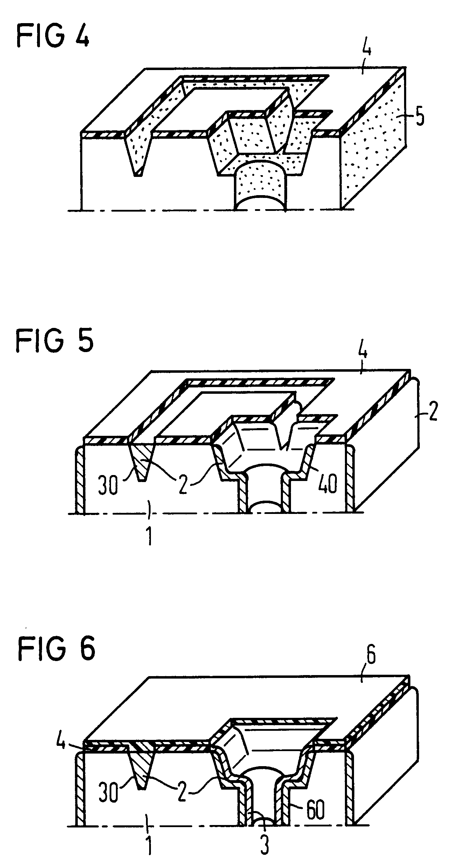

Bei der Herstellung der Leiterplatten wird von einem Substrat 1 ausgegangen, welches als Spritzgußteil in dem Beispiel gemäß Fig. 2 die etwa V-förmig ausgebildeten grabenförmigen Vertiefungen 30 entsprechend dem Leiterbild, die flächigen Vertiefungen 40 und die davon ausgehenden Durchkontaktierungen 60 enthält. Auf die Oberfläche 10 dieses Substrats 1 wird dann nach einer üblichen Oberflächenbehandlung gemäß Fig. 3 eine Lackschicht 4 aufgebracht, bei welcher es sich um ein übliches Plating-Resist handelt. Das Aufbringen der Lackschicht 4 erfolgt durch Roller-Coating, wobei die Vertiefungen 30 und 40 freibleiben. Gemäß Fig. 4 wird nachfolgend eine Bekeimung 5 aufgebracht, die in der Zeichnung durch feine Punkte angedeutet ist. Das Aufbringen dieser Bekeimung 5 erfolgt beispielsweise durch Eintauchen des Substrats 1 in ein PdCl₂-SnCl₂-Bad.

Nach dem Aufbringen der Bekeimung 5 wird diese aktiviert, wobei es sich hier um ein in der Additivtechnik übliches Reduzieren bzw. Beschleunigen handelt. Anschließend wird gemäß Fig. 5 auf die nicht durch eine Lackschicht 4 geschützten Bereiche durch außenstromlose, chemische Metallabscheidung die Metallschicht 2 aufgebracht. Es ist ersichtlich, daß diese in einem handelsüblichen stromlosen Kupferbad aufgebrachte Metallschicht 2 durch eine entsprechende Bemessung der Beschichtungsdauer eine Stärke erreicht hat, die einer vollständigen Ausfüllung der grabenförmigen Vertiefungen 30 bis zur Substratoberfläche entspricht.

Anschließend wird dann gemäß Fig. 6 durch Roller-Coating ein Lötstopplack 6 aufgetragen, welcher die flächigen Vertiefungen 40 und die Durchkontaktierungslöcher 60 als Folge des in Fig. 1 aufgezeigten Abstands A freiläßt und hier das Auftragen der Zinnschicht 3 durch Heißverzinnen ermöglicht. Es ist zu erkennen, daß vor dem Aufbringen des Lötstopplacks 6 die Lackschicht 4 nicht entfernt werden muß.

## Patentansprüche

1. Leiterplatte mit einem spritzgegossenen Substrat (1), in dessen Oberfläche (10) das Leiterbild durch grabenförmige Vertiefungen (30) im Bereich von Leiterbahnen und durch flächige Vertiefungen (40,50) im Bereich von Durchkontaktierungen und/oder Anschlußflächen ausgespart ist und die ausgesparten Bereiche einen leitenden Metallüberzug (2) aufweisen,
**dadurch gekennzeichnet,**
daß die Breite (b) der grabenförmigen Vertiefungen (30) derart eng und die Breite (B) der flächigen Vertiefungen (40,50) derart weit bemessen ist, daß der aufgebrachte Metallüberzug (2) die grabenförmigen Vertiefungen (30) bis zur Oberfläche (10) des Substrats (1) ausfüllt und zwischen dem Metallüberzug (2) in den flächigen Vertiefungen (40,50) und der Oberfläche (10) des Substrats (1) ein Abstand (A) verbleibt.

2. Leiterplatte nach Anspruch 1,
**dadurch gekennzeichnet,**
daß der Metallüberzug (2) im Bereich der flächigen Vertiefungen (40,50) mit einer durch Heißverzinnen aufgebrachten Zinnschicht (3) überzogen ist.

3. Leiterplatte nach Anspruch 1 oder 2,
**dadurch gekennzeichnet,**
daß der Metallüberzug (2) durch chemisch aufgebrachtes Kupfer gebildet ist.

4. Leiterplatte nach einem der vorhergehenden Ansprüche,
**dadurch gekennzeichnet,**
daß die grabenförmigen Vertiefungen (30) einen annähernd V-förmigen Querschnitt aufweisen.

## Claims

1. Printed circuit board having an injection-moulded substrate (1), in the surface (10) of which the conductive pattern is recessed by trench-shaped depressions (30) in the region of conductor tracks and by planar depressions (40, 50) in the region of plated-through holes and/or terminal areas and the recessed regions have a conductive metal coat (2), characterised in that the width (b) of the trench-shaped depressions (30) is dimensioned narrowly and the width (B) of the planar depressions (40, 50) is dimensioned widely in such a way that the applied metal coat (2) fills the trench-shaped depressions (30) up to the surface (10) of the substrate (1) and there remains a distance (A) between the metal coat (2) in the planar depressions (40, 50) and the surface (10) of the substrate (1).

2. Printed circuit board according to Claim 1, characterised in that the metal coat (2) is coated in the region of the planar depressions (40, 50) with a tin layer (3) applied by hot-tinning.

3. Printed circuit board according to Claim 1 or 2, characterised in that the metal coat (2) is formed by chemically applied copper.

4. Printed circuit board according to one of the preceding claims, characterised in that

## Revendications

1. Plaquette à circuits imprimés comportant un substrat (1) moulé par injection, sur la surface (10) duquel la configuration des conducteurs est évidée grâce à la présence de renforcements en forme de sillons (3) situés dans la zone de voies conductrices et par des renfoncements d'une certaine étendue (40,50) situés dans la zone de contacts traversants et/ou de surfaces de raccordement et les zones évidées possèdent un revêtement métallique conducteur (2), caractérisée par le fait que la largeur (b) des renfoncements en forme de sillons (30) est choisie suffisamment étroite et la largeur (b) des renfoncements d'une certaine étendue (40,50) est choisie suffisamment large pour que le revêtement métallique déposé (2) remplisse les renfoncements en forme de sillons (30) jusqu'à la surface (10) du substrat (1) et qu'une distance (A) subsiste entre le revêtement métallique (2) situé dans le renfoncement d'une certaine étendue (40,50) et la surface (10) du substrat (1).

2. Plaquette à circuits imprimés suivant la revendication 1, caractérisée par le fait que le revêtement métallique (2) est recouvert par une couche d'étain (3) déposée par étamage à chaud, dans la zone des renfoncements d'une certaine étendue (40,50).

3. Plaquette à circuits imprimés suivant la revendication 1 ou 2, caractérisée par le fait que le revêtement métallique (2) est formé par du cuivre déposé chimiquement.

4. Plaquette à circuits imprimés suivant l'une des revendications précédentes, caractérisée par le fait que les renfoncements en forme de sillons (30) possèdent une section transversale approximativement en forme de V.
